# EUROPEAN PATENT SPECIFICATION

(11) **EP 0 397 398 B1**
(45) Date of publication and mention of the grant of the patent: **06.08.1997**
(21) Application number: 90304827.0
(22) Date of filing: 03.05.1990
(51) Int. Cl.: H03K 19/094, H03K 19/0175, H03K 19/0185

(54) **A TTL compatible bicmos input circuit**
TTL-kompatible biCMOS-Eingangsschaltung
Circuit d'entrée biCMOS compatible TTL

(30) Priority: 11.05.1989 US 350655
(43) Date of publication of application: 14.11.1990
(73) Proprietor: TEXAS INSTRUMENTS INCORPORATED, Dallas Texas 75265 (US)
(72) Inventor: Mahler, Theodor W., Sherman, Texas 75090 (US); Curtis, Susan A., Sherman, Texas 75090 (US)
(74) Representative: Abbott, David John

(56) References cited:
- DE-A- 2 740 799
- US-A- 4 406 957
- US-A- 4 490 633
- US-A- 4 578 601
- ELECTRONIC COMPONENTS & APPLICATIONS, vol. 7, no. 3, March 1986, pages 151-162, Eindhoven, NL; R. VOLGERS: "Using 74HCT HCMOS to replace LSTTL and drive transmission lines"
- IBM TECHNICAL DISCLOSURE BULLETIN, vol. 16, no. 11, April 1974, pages 3577- 3578, New York, US; P.J. DAOUST et al.: "Small signal receiver circuit for complementary metal-oxide semiconductor circuits"
- ELECTRONIC DESIGN, vol. 25, 6th December 1976, page 112, Rochelle Park, US; R. H.L. SCELIUS: "Simple circuit interfaces TTL to CMOS with use of only a single 12-V supply"

## Description

This invention pertains to an input circuit for a BiCMOS device. More particularly, the invention pertains to a circuit which accepts as input signals having TTL levels and outputs signals having levels acceptable to a BiCMOS circuit. Such interface circuits are referred to as "T" input circuits.

In the issue of Electronic Design dated 6 December 1976 on page 112 an item entitled "Simple circuit interfaces TTL to CMOS with use of only a single 12-v supply" describes a TTL to CMOS interface circuit using a single bipolar transistor in which a TTL input signal is applied to its emitter, its base is connected to an intermediate voltage set by a voltage divider and its connector provides the CMOS output and is connected through a load resistor to the 12-v supply.

US-A-4 490 633 shows in Figure 1 a TTL to CMOS converter circuit having a CMOS inverter from which the CMOS output is obtained, to one gate of which the TTL input is applied directly and to the other gate of which the TTL input is applied through the channel of a MOS transistor, the gate of which is connected to an intermediate voltage. A second MOS transistor is connected from the other gate of the inverter to the high voltage supply and has its gate connected to the CMOS output of the circuit.

### Summary of the Invention

The first object of the invention is to provide a voltage level shifting circuit that will accept as input voltages at TTL levels and transmit as output voltages at CMOS levels.

Another object of the invention is to provide a BiCMOS input circuit that will completely turn off the P-channel transistor of an input inverter constructed with CMOS devices operating under TTL input levels.

Yet another object of the invention is to provide a BiCMos input circuit that will completely turn off a P-channel transistor and thereby greatly reduce the adverse effects of internal ground voltage fluctuations during the operation of the input inverter.

According to the present invention there is provided an interface circuit for receiving TTL voltage signals as input and transmitting CMOS voltage signals as output, comprising
an inverter circuit having a first load device and first and second complementary MOS transistors connected in series between a source of high voltage and a source of low voltage, said MOS transistors having respectively a first and a second gate, which gates are connected together, and an output node for transmitting said CMOS voltage signals,
a second load device connected from the first and second gates of said MOS transistors to said source of high voltage,
a third transistor having a controlled current path connected from the first and second gates of said MOS transistors to an input terminal for the TTL voltage signals, and a control electrode connected to a voltage divider network connected between said source of high voltage and said source of low voltage, the voltage applied to the control electrode of the third transistor being such that the third transistor is conducting for an input signal of a low TTL logic level and is non-conducting for an input signal of a high TTL logic level, and
a speed-up diode connected from the input terminal for the TTL voltage signals to the first and second gates of the MOS transistors.

### BRIEF DESCRIPTION OF THE DRAWINGS

Figure 1 shows a prior art circuit for interfacing between TTL circuits and BiCMOS circuits.

Figures 2a and 2b show additional prior art circuits for interfacing between TTL circuits and BiCMOS circuits.

Figure 3 illustrates a first embodiment of a "T" input circuit.

Figure 4, illustrates a second embodiment of a "T" input circuit.

Figure 5 illustrates an embodiment of an improved "T" circuit according to the present invention.

Figure 6 illustrates a third emboditment of a "T" input circuit.

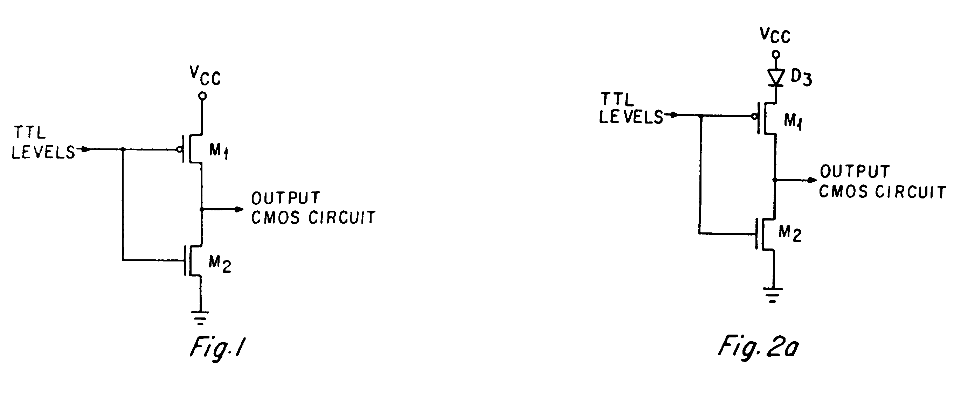

Figure 1 shows a simple conventional "T" input circuit in which a P-channel transistor M1 is connected to an N-channel transistor M2 to form an input inverter circuit.

The ratio of the gate-width of M1 to the gate-width of M2 is skewed such that the resulting gate threshold voltage of the inverter is moved from 2.5 volts to approximately 1.5 volts. While this makes the gate threshold voltage compatible with TTL input signal levels, other problems arise with this method. One such problem is that while the inverter threshold is now 1.5 volts, the voltage at which the P-channel transistor completely turns off is still approximately 3.5 volts. A TTL input voltage level (low = 0.8 v, high = 2.0 v) never achieves a high enough voltage to completely turn the P-channel transistor off. Switching of the inverter is accomplished only because the N-channel transistor is turned on and can sink sufficient current from the still conducting P-channel transistor to cause the inverter output to drop to a low voltage level. Thus, when the input is high, the input inverter will have an undesirable through current that will be dependent on the input voltage level.

Another problem with this method of obtaining "T" inputs is sensitivity to internal ground voltage fluctuations or ground noise. If internal ground voltage shifts up with respect to the input voltage, the voltage differential of the N-channel transistor M2 gate to source will drop enough to turn the M2 transistor off. Since the output of the inverter is low due to the M2 transistor sinking the current from the still-conducting P-channel transistor M1, the output will rise in response to the loss of this current sink. Thus, a false voltage pulse will propagate through the circuit, producing unwanted logic transients.

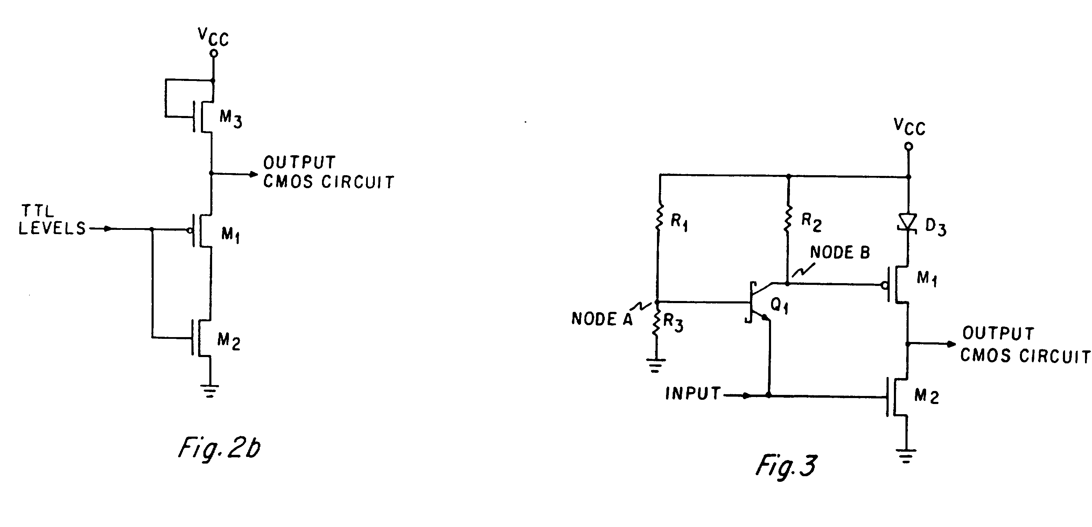

Figures 2a and 2b show another conventional method used to achieve "T" inputs with CMOS circuits. Here a device is placed between the source of the input inverter P-channel transistor M1 and VCC. This device can be either a bipolar diode D1 as shown in Figure 2a or an N-channel transistor M3 connected in a diode configuration as shown in Figure 2b. By using the voltage drop across M3 to lower the voltage at the source of M1, the threshold voltage of M1 will also be lowered. A feedback transistor is sometimes used to short out the diode D3 in Figure 2a so that the output of the inverter will pull up completely to VCC once M1 is conducting. Although the diode D3 drops the threshold voltage of M1, a skewing of the P to N-channel ratio is still needed to completely achieve TTL input thresholds. This method still does not completely turn M1 off and the input remains sensitive to internal ground voltage fluctuations.

Referring to Figure 3, transistors M1 and M2 comprise a standard CMOS input inverter including a dropping diode D3. Components R1, R2, R3, and Q1 are the components added to the standard input inverter. Q1 serves to separate the gates of P-channel transistor M1 from the TTL inputs, allowing the gate to pull up to VCC through R2. Resistors R1 and R3 form a voltage divider network to set the point at which transistor Q1 will turn on.

In operation, with the TTL input at a low voltage level (0.8 v or less), transistor Q1 will be conducting. Node B's voltage level will be equal to the collector emitter voltage (VCE) of transistor Q1, saturated, above the TTL input voltage. At that voltage, M1 will be conducting, pulling the output voltage of the "T" circuit to a high voltage level of VCC minus the voltage drop of the Schottky diode. N-channel transistor M2, with its gate connected to the low voltage input will be off and non-conducting. As the TTL input voltage rises, node B will follow the rise and will equal the level of input voltage plus VCE saturated of M1. As the voltage at node B approaches the threshold voltage of M1, transistor Q1 will begin to turn off, reducing through current to the "T" circuit output from VCC. Also, as the TTL input voltage rises, transistor M2 will turn on, sinking transistor Ml's current and pulling the "T" circuit output voltage to a low level. As the TTL input voltage continues to rise to a high logic level, it will raise the emitter voltage of transistor Q1 until the voltage differential from Q1's base to emitter is insufficient to keep Q1 on: Q1's base voltage being set by the R1-R2 voltage divider network. With transistor Q1 off, the voltage at node B is no longer fixed at a VCE saturated of transistor Q1 above the TTL input voltage and will be pulled to VCC through resistor R2. With the voltage at node B equal to VCC, the transistor M1 will be completely off and non-conducting. In this state, through current from VCC is completely eliminated. Now, if internal ground voltage fluctuations turn the transistor M2 off and the current sink is removed from the "T" circuit output, there will not be a current source pull up to generate a false output pulse from the "T" circuit.

As the TTL input voltage falls below the voltage set by the resistor divider network R1 and R3, the base-emitter junction of transistor Q1 becomes forward biased, turning Q1 on. The voltage at node B now begins to follow the TTL input voltage at a level equal to VCE of transistor Q1 above it. As node B's voltage level falls, it will turn P-channel transistor M1 on, allowing M1 to conduct current to the output of the "T" circuit. Transistor M2 is turned off as the TTL input voltage level falls, removing the conducting path to ground from the "T" output, thus allowing the "T" output to rise to a high voltage level.

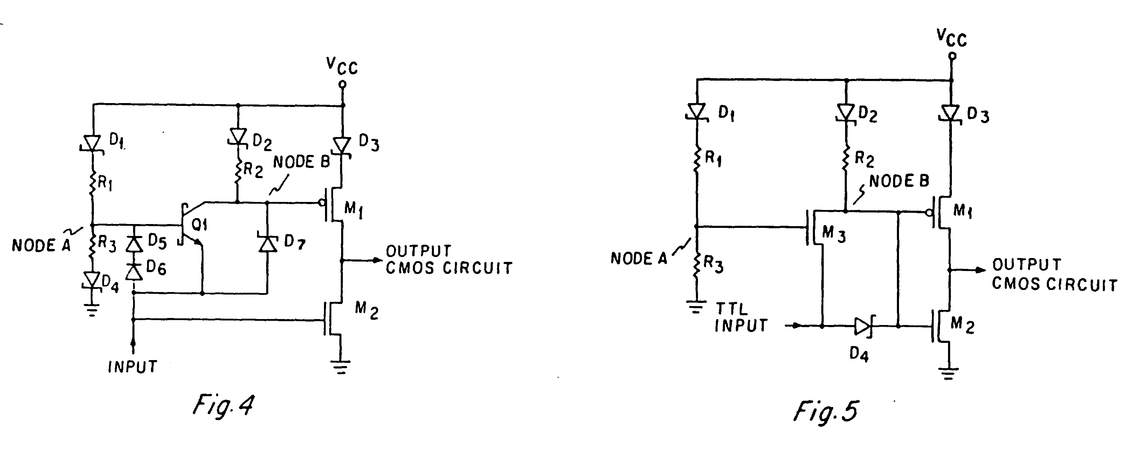

Figure 4 shows an alternative embodiment of the "T" interface circuit. Additional diodes D1, D2, D5, and D6 have been added as shown which allow the circuit to be powered down while the TTL inputs remain connected to active circuitry. Diodes D1 and D2 prevent input current from reaching the VCC nodes of the powered-down "T" circuit.

In this powered-down mode, it is also possible to reverse bias the base-emitter junction of transistor Q1 to a voltage level greater than 3.5 v, which is enough to break it down. Transistor Q1 can be permanently damaged if it is kept in this reverse breakdown voltage condition for an extended period of time. Diodes D5 and D6 prevent the base-emitter junction from being reversed biased to a level greater than twice the base emitter voltage VBE. Diode D4 is used to offset the voltage drop of diode D1 in the resistor divider network R1-R2 and allows smaller resistors to be used. Diode D7 is used to help couple the TTL input pulse to node B, thus providing additional switching speed for the "T" circuit.

Referring to Figure 5, an embodiment of the "T" circuit according to the invention is shown in which a MOS transistor M3 is substituted for the bipolar transistor Q1 'of Figure 4. In this embodiment, transistor M3's threshold voltage is set by components D1, R1, and R3. Transistor M3's gate voltage will be at a different point than the voltage previously set at the base of the bipolar transistor Q1 because of the different thresholds of the MOS transistor M3 and the bipolar transistor Q1.

Analogous with the embodiment of Figure 4, as the input voltage rises, node B also rises until the CMOS inverter consisting of M1 and M2 switches. Notice that the gates of M1 and M2 are connected in this embodiment. This arrangement permits the gates of both transistors to pull to VCC through D2 and R2. Thus, a higher voltage is present on both gates than the voltage level present at the TTL input. This higher voltage level assures a good cutoff of M1 and a good turn on of M2, thereby eliminating any through current and reducing glitch susceptibility of the "T" circuit to internal chip ground voltage fluctuations. As with the embodiment of Figure 4, a speed-up diode D4 AC-couples the TTL input pulse to the gates of M1 and M2, thus providing a capacitive impetus to node B which speeds switching of the "T"

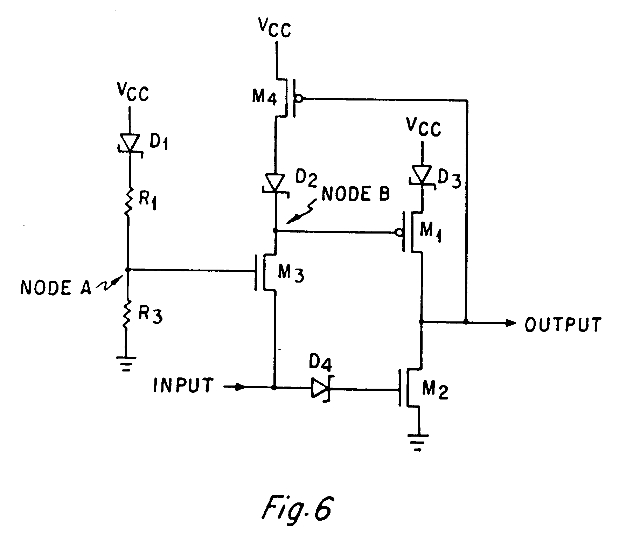

The circuit shown in Figure 6 represents another embodiment of a "T" circuit. This embodiment is the same as that of Figure 5 except that resistor R2 is replaced with P-channel transistor M4 and diode D2 is connected between M4 and node B. Note that M4 has its gate connected to the output of the "T" circuit. In this embodiment, when the TTL input is high and the separating transistor M3 is off, node B is pulled to VCC by transistor M4 through diode D2 similar to the embodiment in Figure 5. When the TTL input voltage signal is low however, the output voltage signal of the circuit will be high thereby turning transistor M4 off. Thus, the small DC input current that may be present in the Figure 5 embodiment for a TTL low input voltage signal is completely eliminated for a high or low TTL input voltage signal in the Figure 6 embodiment. By selecting transistor M4 to be small, and thus resistive, the transient current needed to switch the TTL input from high to low is also kept small. Diode D2 prevents current flow to supply voltage VCC in the event that the current is powered down while the circuit input remains coupled to active circuitry.

## Claims

1. An interface circuit for receiving TTL voltage signals as input and transmitting CMOS voltage signals as output, comprising
an inverter circuit having a first load device (D3) and first and second complementary MOS transistors (M1,M2) connected in series between a source of high voltage (V_{cc}) and a source of low voltage (ground), said MOS transistors having respectively a first and a second gate, which gates are connected together, and an output node for transmitting said CMOS voltage signals,
a second load device (R2,D2) connected from the first and second gates of said MOS transistors to said source of high voltage (Vcc),
a third transistor (M3) having a controlled current path connected from the first and second gates of said MOS transistors to an input terminal for the TTL voltage signals, and a control electrode connected to a voltage divider network (D1,R1,R3) connected between said source of high voltage (Vcc) and said source of low voltage (ground), the voltage applied to the control electrode of the third transistor (M3) being such that the third transistor is conducting for an input signal of a low TTL logic level and is non-conducting for an input signal of a high TTL logic level, and
a speed-up diode (D4) connected from the input terminal for the TTL voltage signals to the first and second gates of the MOS transistors.

2. A circuit according to claim 1 wherein each of the first load device (D3), the second load device (R2,D2) and the voltage divider network (D1,R1,R3) includes a diode.

3. A circuit according to claim 1 or 2 wherein the third transistor (M3) is an MOS transistor.

## Patentansprüche

1. Schnittstellenschaltung zum Empfang von TTL-Spannungs-Signalen als Eingang und zum Senden von CMOS-Spannungs-Signalen als Ausgang mit
einer Inverterschaltung, die eine erste Lastvorrichtung (D3) und erste und zweite komplementäre MOS-Transistoren (M1, M2) hat, die in Serie zwischen einer Quelle hoher Spannung (V_{cc}) und einer Quelle niedriger Spannung (Masse) angeschlossen sind, wobei die MOS-Transistoren ein erstes bzw. ein zweites Gate, die miteinander verbunden sind, und einen Ausgangsknotenpunkt zum Senden der CMOS-Spannungs-Signale haben,
einer zweiten Lastvorrichtung (R2, D2), die von den ersten und zweiten Gates der MOS-Transistoren zu der Quelle hoher Spannung (V_{cc}) angeschlossen ist,
einem dritten Transistor (M3), der einen gesteuerten Strompfad hat, der von den ersten und zweiten Gates der MOS-Transistoren zu einer Eingangsklemme für die TTL-Spannungs-Signale angeschlossen ist, sowie eine Steuerelektrode, die mit einem Spannungsteilernetzwerk (D1, R1, R3) verbunden ist, das zwischen der Quelle hoher Spannung (V_{cc}) und der Quelle niedriger Spannung (Masse) angeschlossen ist, wobei die an die Steuerelektrode des dritten Transistors (M3) angelegte Spannung derart ist, daß der dritte Transistor für ein Eingangssignal eines niedrigen TTL-Logikpegels durchlässig und für ein Eingangssignal eines hohen TTL-Logikpegels gesperrt ist, und
einer Beschleunigungsdiode (D4), die von der Eingangsklemme für die TTL-Spannungs-Signale zu den ersten und zweiten Gates der MOS-Transistoren angeschlossen ist.

2. Schaltung nach Anspruch 1, bei welcher die erste Lastvorrichtung (D3), die zweite Lastvorrichtung (R2, D2) und das Spannungsteilernetzwerk (D1, R1, R3) jeweils eine Diode enthalten.

3. Schaltung nach Anspruch 1 oder 2, bei welcher der dritte Transistor (M3) ein MOS-Transistor ist.

## Revendications

1. Un circuit d'interface pour recevoir des signaux de tension TTL en tant que signaux d'entrée et fournir des signaux de tension CMOS en tant que signaux de sortie,
comprenant un circuit inverseur ayant un premier dispositif de charge (D3) et des premier et deuxième transistors MOS complémentaires (M1, M2) connectés en série entre une source de haute tension (V_{cc}) et une source de basse tension (terre), lesdits transistors MOS ayant respectivement une première et une deuxième porte, lesquelles portes sont connectées ensemble, et un noeud de sortie pour fournir lesdits signaux de tension CMOS,
un deuxième dispositif de charge (R2, D2) connecté depuis les première et deuxième portes desdits transistors MOS à ladite source de haute tension (Vcc) ,
un troisième transistor (M3) ayant un passage de courant commandé connecté depuis les première et deuxième portes desdits transistors MOS à une borne d'entrée pour les signaux de tension TTL, et une électrode de commande connectée à un réseau (D1, R1, R3) diviseur de tension connecté entre ladite source de haute tension (Vcc) et ladite source de basse tension (terre), la tension appliquée à l'électrode de commande du troisième transistor (M3) étant telle que le troisième transistor est conducteur pour un signal d'entrée d'un niveau logique TTL bas et est non-conducteur pour un signal d'entrée d'un niveau logique TTL haut, et
une diode d'accélération (D4) connectée depuis la borne d'entrée pour les signaux de tension TTL aux première et deuxième portes des transistors MOS.

2. Un circuit selon la revendication 1, dans lequel chacun des premier dispositif de charge (D3), deuxième dispositif de charge (R2, D2) et réseau (D1, R1, R3) diviseur de tension, comprend une diode.

3. Un circuit selon la revendication 1 ou 2, dans lequel le troisième transistor (M3) est un transistor MOS.
